# EUROPEAN PATENT APPLICATION

(11) **EP 4 598 317 A1**
(43) Date of publication of application: **06.08.2025**
(21) Application number: 23872963.6
(22) Date of filing: 21.09.2023
(51) Int. Cl.: H10K 50/86, H10K 50/844, H10K 50/84, B32B 7/023, B32B 7/12, B60K 35/00, B60K 37/00, B60J 3/00

(54) **DISPLAY DEVICE AND VEHICLE INCLUDING DISPLAY DEVICE**

(30) Priority: 30.09.2022 KR 20220125484
(71) Applicant: Samsung Display Co., Ltd., Yongin-si, Gyeonggi-do 17113 (KR)
(72) Inventor: KIM, Hyang Yul, Yongin-Si Gyeonggi-do 17113 (KR); KIM, Jae Hong, Yongin-Si Gyeonggi-do 17113 (KR); JUNG, Hyun Ho, Yongin-Si Gyeonggi-do 17113 (KR); JEONG, Hee Seong, Yongin-Si Gyeonggi-do 17113 (KR)
(74) Representative: Dr. Weitzel & Partner
(86) International application number: PCT/KR2023/014438
(87) International publication number: WO 2024/071846

(57) **Abstract**

An embodiment of the present invention provides a display device comprising: a substrate which includes a display area and a non-display area; a display layer which is disposed in the display area and includes a pixel circuit and a light-emitting element; an encapsulation member which covers the display layer; and a light control polarizing film which is disposed on the encapsulation member and includes a transparent layer having a plurality of light-shielding lines arranged therein and a polarizing layer, wherein the plurality of light-shielding lines are arranged closer to the display layer than the polarizing layer.

## Description

### Technical Field

The present disclosure relates to a display apparatus and, more specifically, to a display apparatus including an optical control polarizing film and a vehicle including the same.

### Background Art

Recently, display apparatuses have been used for various purposes. Also, as display apparatuses have become thinner and lighter, the range of their applications has increased, and as display apparatuses have been used in various fields, the demand for display apparatuses for providing high-quality images has increased. Recently, display apparatuses have been installed in vehicles to provide images to users in the driver seat and/or passenger seats.

### Disclosure of Invention

### Technical Problem

Provided is a display apparatus which may be included inside a vehicle and of which the display quality is improved and a vehicle including the display apparatus.

### Solution to Problem

A display apparatus includes a substrate including a display area and a non-display area. A display layer is disposed in the display area and includes a pixel circuit and a light-emitting device. An encapsulation structure at least partially covers the display layer. An optical control polarization film is disposed on the encapsulation structure and includes a transparent layer and a polarization layer. A plurality of light blocking lines are disposed in the transparent layer. The plurality of light blocking lines are disposed closer to the display layer than to the polarization layer.

### Advantageous Effects of Invention

As described above, according to embodiments, because an optical control polarization film in which a plurality of light blocking lines are disposed closer to a display layer than a polarization layer is provided, the quality of a display apparatus may be increased.

### Brief Description of Drawings

The above and other aspects and features of certain embodiments will be more apparent from the following description taken in conjunction with the accompanying drawings, in which:
FIG. 1 is a view schematically illustrating an appearance of a vehicle, according to an embodiment;
FIG. 2A is a view schematically illustrating the inside of a vehicle, according to an embodiment;
FIG. 2B is a view schematically illustrating the inside of a vehicle, according to an embodiment;
FIG. 3 is a perspective view schematically illustrating a display apparatus, according to an embodiment;
FIG. 4A is a cross-sectional view taken along line A-A' of the display apparatus of FIG. 3, according to an embodiment;
FIG. 4B is a cross-sectional view taken along line A-A' of the display apparatus of FIG. 3, according to an embodiment;
FIG. 4C is a cross-sectional view taken along line A-A' of the display apparatus of FIG. 3, according to an embodiment;
FIG. 5 is a cross-sectional view schematically illustrating an optical control polarization film, according to an embodiment;
FIGS. 6A to 6E are cross-sectional views sequentially illustrating a method of manufacturing an optical control polarization film, according to an embodiment;
FIG. 7 is a plan view illustrating a part of an optical control polarization film;
FIG. 8 is a plan view schematically illustrating a display apparatus, according to an embodiment;
FIG. 9 is an equivalent circuit diagram schematically illustrating a sub-pixel, according to an embodiment;
FIG. 10 is a cross-sectional view taken along line I-I' schematically illustrating a part of the display apparatus of FIG. 9, according to an embodiment; and
FIG. 11 is a cross-sectional view taken along line I-I' schematically illustrating a part of the display apparatus of FIG. 9, according to an embodiment.

### Best Mode for Carrying out the Invention

A display apparatus includes a substrate including a display area and a non-display area. A display layer is disposed in the display area and includes a pixel circuit and a light-emitting device. An encapsulation structure at least partially covers the display layer. An optical control polarization film is disposed on the encapsulation structure and includes a transparent layer and a polarization layer. A plurality of light blocking lines are disposed in the transparent layer. The plurality of light blocking lines are disposed closer to the display layer than to the polarization layer.

The plurality of light blocking lines may extend in a first direction, the plurality of light blocking lines may extend in a second direction, and an absorption axis of the polarization layer may also extend in the second direction.

The transparent layer may include a plurality of grooves, and the plurality of light blocking lines may respectively fill the plurality of grooves.

The optical control polarization film may further include a first protective layer disposed between the transparent layer and the polarization layer. The transparent layer may be in direct contact with the first protective layer. The first protective layer may include tri-acetyl cellulose (TAC), cyclo-olefin polymer, and/or polymethyl methacrylate (PMMA).

A vertical distance from an emission layer of the light-emitting device to the plurality of light blocking lines may range from about 10 µm to about 300 µm.

The plurality of light blocking lines may be spaced apart from each other at a first interval in one direction.

A width of an emission area of the light-emitting device in the one direction may be a multiple of the first interval.

The encapsulation structure may include an encapsulation layer in which at least one inorganic encapsulation layer and at least one organic encapsulation layer are alternately stacked.

The encapsulation structure may include an encapsulation substrate disposed on the display layer and a sealing structure configured to bond the substrate to the encapsulation substrate in the non-display area.

An adhesive layer may be disposed on a surface of the optical control polarization film facing the encapsulation structure.

The optical control polarization film may further include a hard coating layer disposed on the polarization layer. The hard coating layer may have a hardness of about 3 H to about 9 H.

A vehicle includes a pair of side window glasses spaced apart from each other in a first direction. A display apparatus is disposed between the pair of side window glasses. The display apparatus includes a substrate including a display area and a non-display area. A display layer is disposed in the display area and includes a pixel circuit and a light-emitting device. An encapsulation structure at least partially covers the display layer. An optical control polarization film is disposed on the encapsulation structure and includes a transparent layer and a polarization layer. A plurality of light blocking lines are disposed in the transparent layer. The plurality of light blocking lines are disposed closer to the display layer than to the polarization layer.

The plurality of light blocking lines may extend in a first direction, the plurality of light blocking lines may extend in a second direction, and an absorption axis of the polarization layer may also extend in the second direction.

The transparent layer may include a plurality of grooves, and the plurality of light blocking lines may respectively fill the plurality of grooves.

The optical control polarization film may further include a first protective layer disposed between the transparent layer and the polarization layer. The transparent layer may be in direct contact with the first protective layer. The first protective layer may include tri-acetyl cellulose (TAC), cyclo-olefin polymer, and/or polymethyl methacrylate (PMMA).

A vertical distance from an emission layer of the light-emitting device to the plurality of light blocking lines may range from about 10 µm to about 300 µm.

The encapsulation structure may include an encapsulation layer in which at least one inorganic encapsulation layer and at least one organic encapsulation layer are alternately stacked.

The encapsulation structure may include an encapsulation substrate disposed on the display layer and a sealing structure configured to bond the substrate to the encapsulation substrate in the non-display area.

An adhesive layer may be disposed on a surface of the optical control polarization film facing the encapsulation structure.

The optical control polarization film may further include a hard coating layer disposed on the polarization layer, and the hard coating layer has a hardness of about 3H to about 9H.

### Mode for the Invention

Reference will now be made in detail to embodiments, examples of which are illustrated in the accompanying drawings, wherein like reference numerals may refer to like elements throughout the specification and the drawings. In this regard, the present embodiments may have different forms and should not necessarily be construed as being limited to the descriptions set forth herein. Accordingly, the embodiments are merely described below, by referring to the figures, to explain aspects of the present description. As used herein, the term "and/or" includes any and all combinations of one or more of the associated listed items.

As the disclosure allows for various changes and numerous embodiments, certain embodiments will be illustrated in the drawings and described in the detailed description. Effects and features of the disclosure, and methods for achieving them will be clarified with reference to embodiments described below in detail with reference to the drawings. However, the disclosure is not necessarily limited to the following embodiments and may be embodied in various forms.

Although the terms "first," "second," etc. may be used to describe various elements, these elements should not necessarily be limited by these terms. These terms are used to distinguish one element from another.

As used herein, the singular forms "a," "an," and "the" are intended to include the plural forms as well, unless the context clearly indicates otherwise.

It will be further understood that the terms "comprises" or "comprising" used herein specify the presence of stated features or components, but do not preclude the presence or addition of one or more other features or components.

It will be further understood that, when a layer, region, or component is referred to as being "on" another layer, region, or component, it may be directly on the other layer, region, or component, or may be indirectly on the other layer, region, or component with intervening layers, regions, or components therebetween.

While each drawing may represent one or more particular embodiments of the present, drawn to scale, such that the relative lengths, thicknesses, and angles can be inferred therefrom, it is to be understood that the present invention is not necessarily limited to the relative lengths, thicknesses, and angles shown. Changes to these values may be made within the spirit and scope of the present disclosure, for example, to allow for manufacturing limitations and the like.

When a certain embodiment may be implemented differently, a specific process order may be different from the described order. For example, two consecutively described processes may be performed substantially at the same time or may be performed in an order opposite to the described order.

It will be understood that when a layer, region, or component is referred to as being "connected," the layer, the region, or the component may be directly connected or may be indirectly connected with intervening layers, regions, or components therebetween. For example, when layers, regions, or components are referred to as being "electrically connected," the layers, the regions, or the components may be directly electrically connected, or may be indirectly electrically connected with intervening layers, regions, or components therebetween.

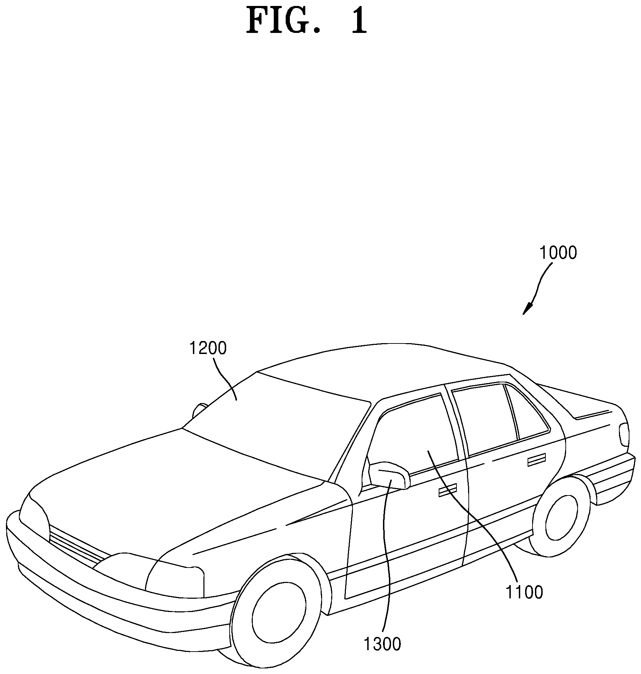

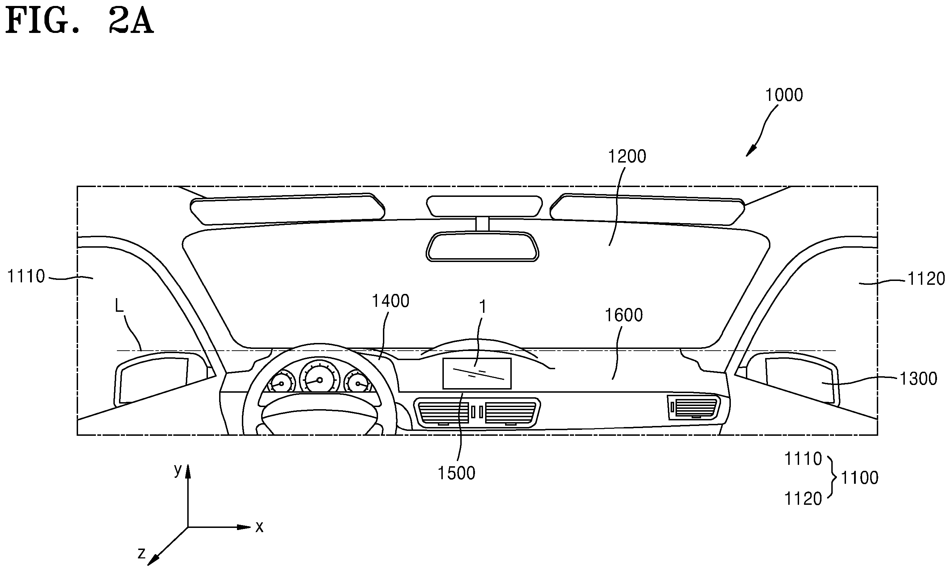

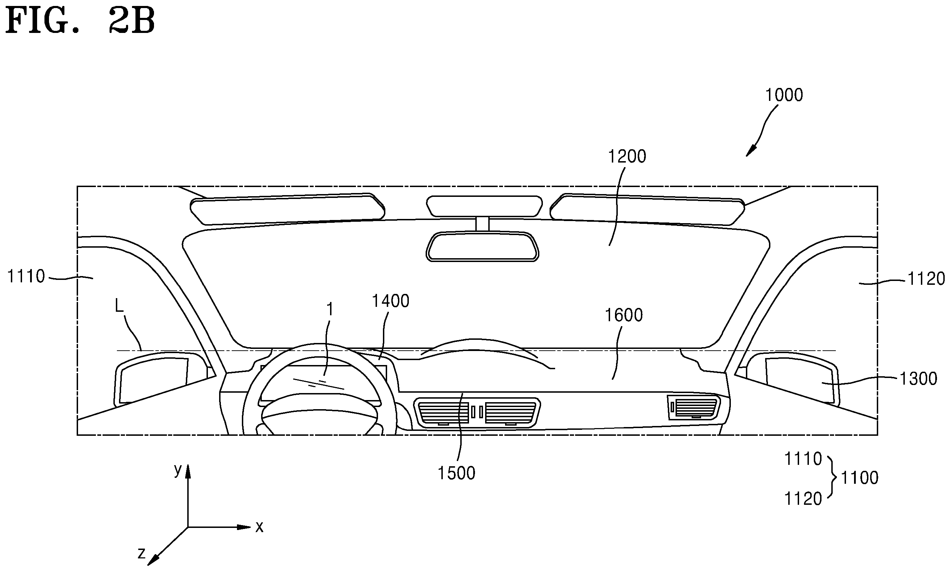

FIG. 1 is a view schematically illustrating an appearance of a vehicle 1000, according to an embodiment. FIGS. 2A and 2B are views schematically illustrating the inside of the vehicle 1000, according to an embodiment.

Referring to FIGS. 1, 2A, and 2B, the vehicle 1000 may refer to any of various devices for moving a transported object such as passengers, cargo, or an animal from a starting point to a destination. Examples of the vehicle 1000 may include a vehicle traveling on a road or a track, a vessel moving on the sea or river, and an airplane flying in the sky using the action of air.

The vehicle 1000 may travel on a road or a track. The vehicle 1000 may move in a certain direction according to the rotation of at least one wheel. Examples of the vehicle 1000 may include a three or four-wheeled vehicle, a construction machine, a two-wheeled vehicle, a moped, a bicycle, and a train running on a track.

The vehicle 1000 may include a body including an interior and an exterior, and a chassis that is a portion other than the body and on which mechanical devices required for driving are installed. The exterior of the body may include a filler provided at a boundary between a front panel, a bonnet, a roof panel, a rear panel, a trunk, and a door. The chassis of the vehicle 1000 may include a power generating device, a power storing device, a power transmitting device, a driving device, a steering device, a braking device, a suspension device, a transmission device, a fuel device, and/or front, rear, left, and/or right wheels. The vehicle 1000 may include a side window glass 1100, a front window glass 1200, a side mirror 1300, an instrument cluster 1400, a center fascia 1500, a passenger seat dashboard 1600, and a display apparatus 1.

The side window glass 1100 and the front window glass 1200 may be divided by a filler disposed between the side window glass 1100 and the front window glass 1200.

The side window glass 1100 may be installed on a side surface of the vehicle 1000. In an embodiment, the side window glass 1100 may be installed on a door of the vehicle 1000. A plurality of side window glasses 1100 may be provided to face one another. In an embodiment, the side window glass 1100 may include a first side window glass 1110 and a second side window glass 1120. The first side window glass 1110 may be disposed adjacent to the instrument cluster 1400. The second side window glass 1120 may be disposed adjacent to the passenger seat dashboard 1600.

The side window glasses 1100 may be spaced apart from each other in a first direction (e.g., an x direction). For example, the first side window glass 1110 and the second side window glass 1120 may be spaced apart from each other in the x direction. For example, an imaginary straight line L that connects the side window glasses 1100 may extend in the first direction (e.g., the x direction).

The front window glass 1200 may be provided in a front portion of the vehicle 1000. The front window glass 1200 may be disposed between the pair of side window glasses 1100 that face each other.

The side mirror 1300 may provide a rear view of the vehicle 1000. The side mirror 1300 may be provided on the exterior of the body. A plurality of side mirrors 1300 may be provided. Any one of the plurality of side mirrors 1300 may be disposed outside the first side window glass 1110. Another one of the plurality of side mirrors 1300 may be disposed outside the second side window glass 1120.

The instrument cluster 1400 may be disposed in front of a steering wheel. The instrument cluster 1400 may include a tachometer, a speedometer, a coolant thermometer, a fuel gauge, a turn signal indicator, a high beam warning light, a warning light, a seat belt warning light, an odometer, an odograph, an automatic transmission selection lever indicator, a door open warning light, an engine oil warning light, and/or a low fuel warning light. These elements may be analog instruments and/or digital displays.

The center fascia 1500 may include a control panel on which a plurality of buttons for adjusting an audio device, an air conditioning device, and a heater of a seat are disposed. The center fascia 1500 may be disposed on a side of the instrument cluster 1400.

The passenger seat dashboard 1600 may be spaced apart from the instrument cluster 1400 with the center fascia 1500 disposed therebetween. In an embodiment, the instrument cluster 1400 may be disposed to correspond to a driver seat, and the passenger seat dashboard 1600 may correspond to a passenger seat. In an embodiment, the instrument cluster 1400 may be adjacent to the first side window glass 1110, and the passenger seat dashboard 1600 may be adjacent to the second side window glass 1120. The display apparatus 1 may be disposed inside the vehicle 1000. The display apparatus 1 may be disposed between the side window glasses 1100. The display apparatus 1 may display an image. The display apparatus 1 may be disposed on at least one of the instrument cluster 1400, the center fascia 1500, and the passenger seat dashboard 1600. Examples of the display apparatus 1 may include a liquid-crystal display, an electrophoretic display, an organic light-emitting display, an inorganic light-emitting display, a field-emission display, a surface-conduction electron-emitter display, a quantum dot display, a plasma display, and a cathode ray display. Although an organic light-emitting display apparatus is used as the display apparatus 1 according to an embodiment, any of various display apparatuses as described above may be used. Referring to FIG. 2A, the display apparatus 1 may be disposed on the center fascia 1500. In an embodiment, the display apparatus 1 may display navigation information. In an embodiment, the display apparatus 1 may display information about an audio, a video, or vehicle settings.

Light emitted by the display apparatus 1 may travel in a specific direction. For example, light emitted by the display apparatus 1 may travel to the driver seat. Light emitted by the display apparatus 1 may travel to the passenger seat. Light emitted by the display apparatus 1 might not travel to the front window glass 1200. Alternatively, light emitted by the display apparatus 1 may travel to the front window glass 1200. When light emitted by the display apparatus 1 travels to the front window glass 1200, the light emitted by the display apparatus 1 may be reflected by the front window glass 1200 to the driver seat. Accordingly, a driver may perceive an image of the display apparatus 1 formed on the front window glass 1200 and might not perceive an object ahead, thereby causing safety problems while driving. In the present embodiment, light emitted by the display apparatus 1 disposed on the center fascia 1500 may travel in a specific direction. Accordingly, light traveling to the front window glass 1200 may be minimized.

Referring to FIG. 2B, the display apparatus 1 may be disposed in the instrument cluster 1400. In this case, the instrument cluster 1400 may display driving information by using the display apparatus 1. For example, the instrument cluster 1400 may operate in a digital manner. The instrument cluster 1400 operating in a digital manner may display vehicle information and driving information as images. For example, needles and gauges of the tachometer and various warning light icons may be displayed by using digital signals. Light emitted by the display apparatus 1 may travel in a specific direction. For example, light emitted by the display apparatus 1 may travel to the driver seat. Light emitted by the display apparatus 1 might not travel to the front window glass 1200. Alternatively, light emitted by the display apparatus 1 may travel to the front window glass 1200. When light emitted by the display apparatus 1 travels to the front window glass 1200, the light emitted by the display apparatus 1 may be reflected by the front window glass 1200 to the driver seat. Accordingly, the driver may perceive an image of the display apparatus 1 formed on the front window glass 1200, thereby causing safety problems while driving. In the present embodiment, light emitted by the display apparatus 1 disposed in the instrument cluster 1400 may travel in a specific direction. Accordingly, light traveling to the front window glass 1200 may be minimized.

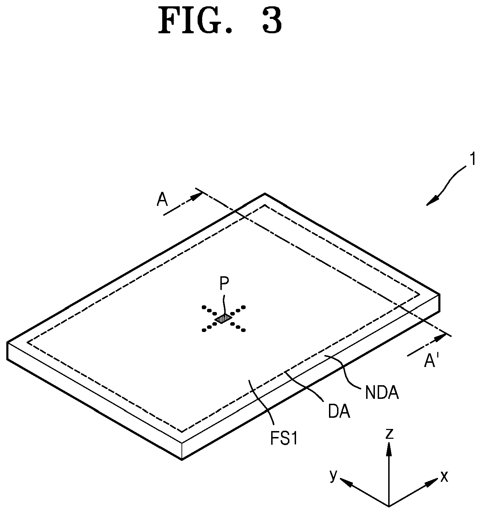

FIG. 3 is a perspective view schematically illustrating the display apparatus 1, according to an embodiment.

Referring to FIG. 3, the display apparatus 1 may include a display area DA and a non-display area NDA. A sub-pixel P may be disposed in the display area DA. In an embodiment, the sub-pixel P may be disposed on a front surface FS1 of the display apparatus 1.

A plurality of sub-pixels P may be disposed in the display area DA. The sub-pixel P may be implemented as a light-emitting device. Light emitted by the sub-pixel P may travel in a specific direction from the front surface FS1 of the display apparatus 1. Light emitted by the sub-pixel P might not travel in another specific direction from the front surface FS1 of the display apparatus 1. In an embodiment, light emitted by the sub-pixel P may travel in a direction perpendicular to the front surface FS1 of the display apparatus 1 (e.g., a z direction). Light emitted by the sub-pixel P may travel in a direction oblique to the front surface FS1 of the display apparatus 1 (e.g., a direction intersecting the z direction). In an embodiment, light emitted by the sub-pixel P might not have a component of the first direction (e.g., the x direction) or a second direction (e.g., a y direction).

The sub-pixel P may emit red light, green light, or blue light by using a light-emitting device. In an embodiment, the sub-pixel P may emit red light, green light, blue light, or white light by using a light-emitting device. The sub-pixel P may be defined as an emission area of a light-emitting device that emits light of a color from among red, green, blue, and white. The sub-pixel P may include a light-emitting diode as a light-emitting device capable of emitting light of a certain color. The light-emitting diode may include an organic light-emitting diode including an organic material as an emission layer. Alternatively, the light-emitting diode may include an inorganic light-emitting diode. Alternatively, the light-emitting diode may include quantum dots as an emission layer. In an embodiment, the light-emitting diode may have a micro-scale or nano-scale size. For example, the light-emitting diode may be a micro light-emitting diode. Alternatively, the light-emitting diode may be a nano light-emitting diode. The nano light-emitting diode may include gallium nitride (GaN). In an embodiment, a color conversion layer may be disposed on the nano light-emitting diode. The color conversion layer may include quantum dots. For convenience of explanation, the following will be described assuming that the light-emitting diode includes an organic light-emitting diode.

The non-display area NDA may be an area where an image is not provided. The non-display area NDA may at least partially surround the display area DA. In an embodiment, the non-display area NDA may entirely surround the display area DA. A driver or the like for applying an electrical signal or power to the sub-pixel P may be disposed in the non-display area NDA. Also, the non-display area NDA may include a pad area where a pad is disposed.

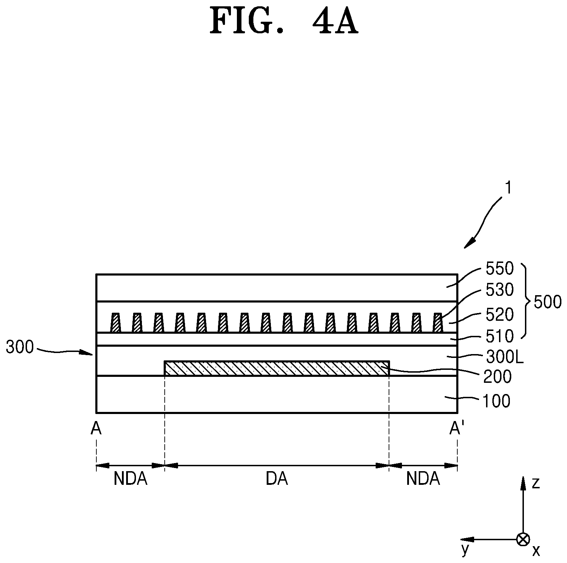

FIGS. 4A to 4C are cross-sectional views taken along line A-A' of the display apparatus 1 of FIG. 3.

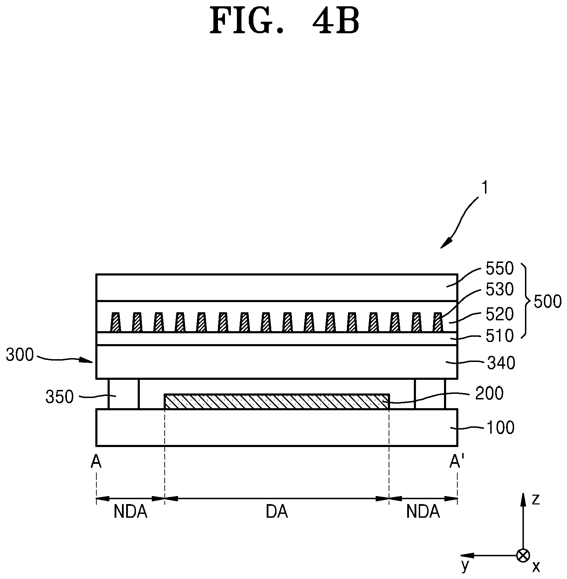

Referring to FIGS. 4A and 4B, the display apparatus 1 may include a substrate 100, a display layer 200, an encapsulation structure 300, and an optical control polarization film 500. The substrate 100 may include glass or a polymer resin such as polyethersulfone, polyarylate, polyetherimide, polyethylene naphthalate, polyethylene terephthalate, polyphenylene sulfide, polyimide, polycarbonate, cellulose triacetate, or cellulose acetate propionate. In an embodiment, the substrate 100 may have a multi-layer structure including a base layer including the polymer resin and a barrier layer. The substrate 100 including the polymer resin may be flexible, rollable, or bendable.

The display layer 200 may be disposed on the substrate 100. The display layer 200 may include a pixel circuit layer and a light-emitting device layer. The pixel circuit layer may include a pixel circuit. The pixel circuit may include a transistor and a storage capacitor. The light-emitting device layer may include a light-emitting device connected to the pixel circuit.

Referring to FIG. 4A, the encapsulation structure 300 may include an encapsulation layer 300L. The encapsulation layer 300L may include at least one inorganic encapsulation layer and at least one organic encapsulation layer. The at least one inorganic encapsulation layer and the at least one organic encapsulation layer may be alternately stacked. The at least one inorganic encapsulation layer may include aluminum oxide (Al₂O₃), titanium oxide (TiO₂), tantalum oxide (Ta₂O₅), zinc oxide (ZnOₓ), silicon oxide (SiO₂), silicon nitride (SiNₓ), and/or silicon oxynitride (SiON). The zinc oxide (ZnOₓ) may include zinc oxide (ZnO) and/or zinc peroxide (ZnO₂).

The at least one organic encapsulation layer may include a polymer-based material. Examples of the polymer-based material may include an acrylic resin, an epoxy resin, polyimide, and polyethylene. In an embodiment, the at least one organic encapsulation layer may include acrylate.

Referring to FIG. 4B, the encapsulation structure 300 may include an encapsulation substrate 340 and a sealing structure 350. The encapsulation substrate 340 may be disposed on the display layer 200. The sealing structure 350 may be disposed between the substrate 100 and the encapsulation substrate 340 in the non-display area NDA. The encapsulation substrate 340 may have a thickness that is similar to that of the substrate 100. For example, a thickness of each of the substrate 100 and the encapsulation substrate 340 may be about 0.3 mm. An inner space between the display layer 200 and the encapsulation substrate 340 may be sealed. The sealing structure 350 may be a sealant. In an embodiment, the sealing structure 350 may include a material that is cured by a laser. For example, the sealing structure 350 may be a frit. For example, the sealing structure 350 may include a urethane resin, an epoxy resin, or an acrylic resin that is an organic sealant, or an inorganic sealant. In an embodiment, the sealing structure 350 may include silicone. Examples of the urethane resin may include urethane acrylate. Examples of the acrylic resin may include butyl acrylate and ethylhexyl acrylate. The sealing structure 350 may include a material that is cured by heat.

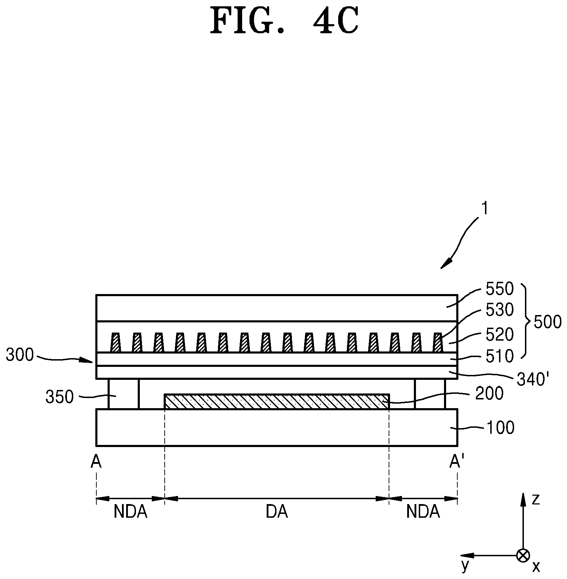

Referring to FIG. 4C, the encapsulation structure 300 may include an encapsulation substrate 340' and the sealing structure 350. The encapsulation substrate 340' may have a thickness less than that of the substrate 100. For example, a thickness of the encapsulation substrate 340' may be 1/3 of a thickness of the substrate 100. In some embodiments, a thickness of the encapsulation substrate 340' may be about 0.1 mm. The encapsulation substrate 340' may be formed by bonding the encapsulation substrate 340 of FIG. 4B to the substrate 100 by using the sealing structure 350 and then adjusting a thickness through a grinding process.

Referring to FIGS. 4A to 4C, the optical control polarization film 500 may be disposed on the encapsulation structure 300. The optical control polarization film 500 may reduce a reflectance of light (e.g., external light) incident on the display apparatus 1 and may control a traveling direction of light emitted by the display layer 200. For example, a component of the second direction (e.g., the y direction) in light emitted by the display layer 200 may be at least partially removed by the optical control polarization film 500. The optical control polarization film 500 may include an adhesive layer 510, a transparent layer 520, a plurality of light blocking lines 530, and a polarization film layer 550.

The adhesive layer 510 may be disposed in a lower portion of the optical control polarization film 500, and may enable the optical control polarization film 500 to be attached to the encapsulation structure 300. The adhesive layer 510 may be a pressure sensitive adhesive (PSA).

The transparent layer 520 may be formed of a resin having a relatively high light transmittance. For example, the transparent layer 520 may include a cellulose resin, a polyolefin resin, a polyester resin, polystyrene, plolyurethane, polyvinyl chloride, or an acrylic resin. The transparent layer 520 may include a plurality of grooves. The plurality of grooves may be arranged at a regular interval.

The plurality of light blocking lines 530 may respectively fill the plurality of grooves of the transparent layer 520. The plurality of light blocking lines 530 may include a light blocking material. For example, the plurality of light blocking lines 530 may include a black material. The plurality of light blocking lines 530 may be formed by filling black ink in each of the plurality of grooves and exposing the filled grooves to ultraviolet rays. According to an arrangement of the plurality of light blocking lines 530, a path of light emitted by the display layer 200 may be controlled.

The polarization film layer 550 may be disposed on the transparent layer 520 and the plurality of light blocking lines 530. For example, the polarization film layer 550 may be disposed farther from the display layer 200 than to the plurality of light blocking lines 530. The plurality of light blocking lines 530 may be disposed closer to the display layer 200 than to the polarization film layer 550.

The polarization film layer 550 may include a polarization layer and a phase retardation layer. The phase retardation layer may be a film-type phase retardation layer or a liquid crystal coating-type phase retardation layer, and may include a λ/2 phase retarder (e.g., a half-wave plate) and/or a λ/4 phase retarder (e.g., a quarter-wave plate). The polarization layer may also be a film-type polarization layer or a liquid crystal coating-type polarization layer. The film-type polarization layer may include a stretchable synthetic resin film, and the liquid crystal coating-type polarization layer may include liquid crystals arranged in a certain arrangement. The polarization film layer 550 may further include a protective layer disposed over and/or under the polarization layer and the phase retardation layer. The polarization film layer 550 may reduce a reflectance of light (e.g., external light) incident on the display apparatus 1.

In general, in order to form the plurality of light blocking lines 530 for controlling an optical path, the transparent layer 520 and the plurality of light blocking lines 530 may be formed on a base film formed of polycarbonate or polyethylene terephthalate (PET). Next, a polarization film and the base film on which the plurality of light blocking lines 530 are formed may be attached by using an optically transparent adhesive layer and may be disposed on an encapsulation structure.

In this case, because the base film has double refraction, when the base film is disposed on the display layer 200, a ghost image may be formed. Due to thicknesses of the base film and the optically transparent adhesive layer, a distance between the display layer 200 and the plurality of light blocking lines 530 may increase, thereby causing a ghost image having a relatively large size to be visible.

In the present embodiment, the optical control polarization film 500 in which the transparent layer 520 and the plurality of light blocking lines 530 are directly formed under the polarization film layer 550 may be provided, so that the plurality of light blocking lines 530 are disposed adjacent to the display layer 200 without using an optically transparent adhesive layer and a base film formed of polycarbonate or PET.

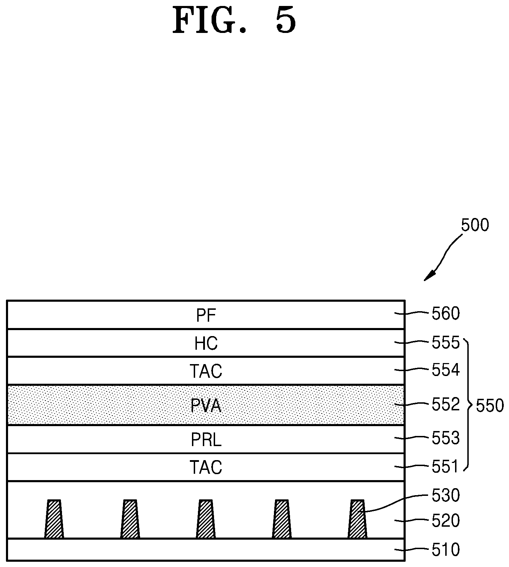

FIG. 5 is a cross-sectional view schematically illustrating the optical control polarization film 500, according to an embodiment. In FIG. 5, the same structures as those in FIGS. 4A to 4C may be denoted by the same reference numerals.

Referring to FIG. 5, the optical control polarization film 500 includes the adhesive layer 510, the transparent layer 520, the plurality of light blocking lines 530, and the polarization film layer 550. A protective film 560 may be further disposed on the polarization film layer 550.

In the optical control polarization film 500, the transparent layer 520 in which the plurality of light blocking lines 530 are disposed is disposed directly on the polarization film layer 550 including a polarization layer 552. The plurality of light blocking lines 530 may respectively fill a plurality of grooves of the transparent layer 520.

The polarization film layer 550 may include a first protective layer 551, a phase retardation layer 553, the polarization layer 552, a second protective layer 554, and a hard coating layer 555.

The polarization layer 552 polarizes light incident from a light source into light of the same direction as a polarization axis. In some embodiments, the polarization layer 552 may include a polarizer and/or a dichroic dye in a polyvinyl alcohol (PVA) film. The dichroic dye may be iodine molecules and/or dye molecules.

In some embodiments, the polarization layer 552 may be formed by stretching a PVA film in one direction and immersing the PVA film in a solution of iodine and/or dichroic dye. In this case, iodine molecules and/or dichroic dye molecules are arranged in a direction parallel to a stretching direction. Because the iodine molecules and the dye molecules exhibit dichroism, the iodine molecules and the dye molecules may absorb light vibrating in the stretching direction and may transmit light vibrating in a direction perpendicular to the stretching direction.

The phase retardation layer (PRL) 553 may be disposed on a side of the polarization layer 552, to delay a phase of light reflected by a metal layer or the like in a display panel. For example, the phase retardation layer 553 may circularly polarize by delaying a phase of reflected light by λ/4. Accordingly, a reflectance of light may be reduced. In some embodiments, the phase retardation layer 553 may have a wavelength dependence, and a phase retardation value may decrease toward a shorter wavelength. As shown in FIG. 5, the phase retardation layer 553 may be disposed under the polarization layer 552. The first protective layer 551 and the second protective layer 554 may support the polarization layer 552 and the phase retardation layer 553 to compensate for the mechanical strength of the polarization layer 552 and the phase retardation layer 553. The first protective layer 551 may be disposed under the phase retardation layer 553. The second protective layer 554 may be disposed over the polarization layer 552. Alternatively, various modifications may be made. For example, the second protective layer 554 may be disposed between the polarization layer 552 and the phase retardation layer 553. Each of the first protective layer 551 and the second protective layer 554 may include tri-acetyl cellulose (TAC), cyclo-olefin polymer, or polymethyl methacrylate (PMMA).

The hard coating layer 555 may be an element for protecting a configuration of the polarization film layer 550 from external impact. The hard coating layer 555 may have a scratch-resistant function, and may have a hardness of about 3H to about 9H. As the hard coating layer 555 is disposed above the transparent layer 520 in which the plurality of light blocking lines 530 are disposed, up to the transparent layer 520 may be protected by the hard coating layer 555.

The protective film 560 may be disposed on the hard coating layer 555. The protective film 560, that is a temporary film for protecting the polarization film layer 550, may be removed later.

In the present embodiment, the transparent layer 520 in which the plurality of light blocking lines 530 are disposed may directly contact the first protective layer 551. For example, in the present embodiment, because the transparent layer 520 is directly disposed on a side of the polarization film layer 550, a separate base film for forming the transparent layer 520 and the plurality of light blocking lines 530 is not required. Accordingly, an overall thickness of the optical control polarization film may be reduced, and a ghost image due to double refraction of the base film might not appear.

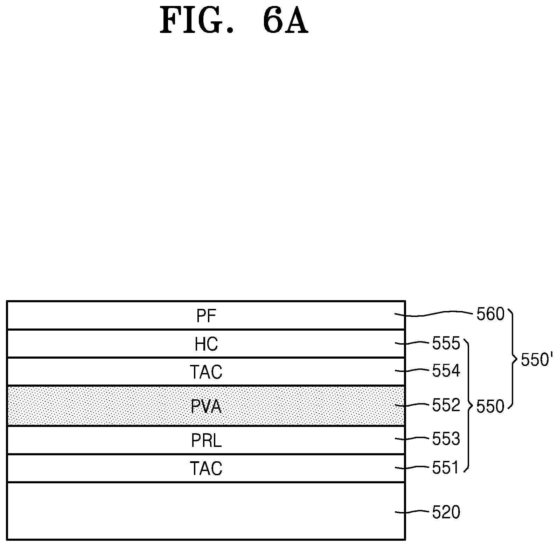

FIGS. 6A to 6E are cross-sectional views sequentially illustrating a method of manufacturing the optical control polarization film 500, according to an embodiment.

Referring to FIG. 6A, a polarization film 550', in which the protective film 560 is attached to the polarization film layer 550, is prepared. The polarization film 550' may be a roll-type polarization film obtained through a roll-to-roll process. In this case, the polarization film 550' does not include an adhesive layer.

Next, the transparent layer 520 is formed on a surface of the polarization film layer 550 to which the protective film 560 is not attached. For example, the transparent layer 520 is formed on a bottom surface of the first protective layer 551 of the polarization film layer 550. The transparent layer 520 may be a resin having a high light transmittance and cured by UV light. For example, the transparent layer 520 may include a cellulose resin, a polyolefin resin, a polyester resin, polystyrene, polyurethane, polyvinyl chloride, or an acrylic resin.

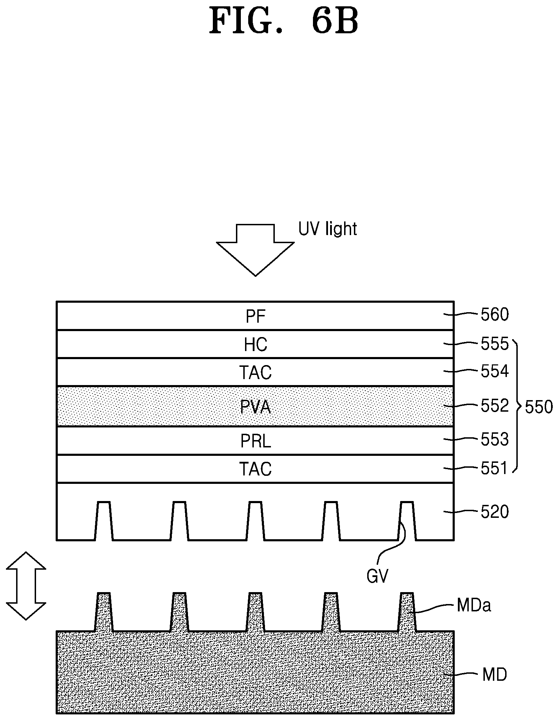

Next, referring to FIG. 6B, a mold MD including a plurality of protrusions MDa is pressed against the transparent layer 520. Accordingly, a plurality of grooves GV corresponding to the plurality of protrusions Mda may be formed in the transparent layer 520. In this case, the transparent layer 520 may be cured by casting UV light to a top surface of the protective film 560. The groove GV may be provided so that the area of the groove GV decreases away from a bottom surface of the transparent layer 520 toward a top surface of the transparent layer 520.

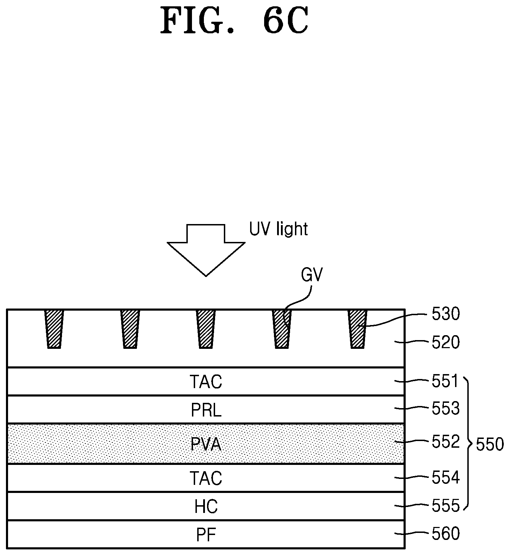

Next, referring to FIG. 6C, the plurality of light blocking lines 530 are formed by filling a light blocking material in the plurality of grooves GV formed in the transparent layer 520. For example, the light blocking material may include a black dye or the like. The plurality of light blocking lines 530 may be formed by applying a light blocking material to an entire surface of the transparent layer 520 to form black ink light blocking lines 530 in the plurality of grooves and then removing the light blocking material applied to portions other than the grooves GV. The light blocking material may be filled in the grooves GV and then may be cured by using UV curing or thermal curing. According to an arrangement of the plurality of light blocking lines 530, a path of light emitted by the display layer 200 may be controlled.

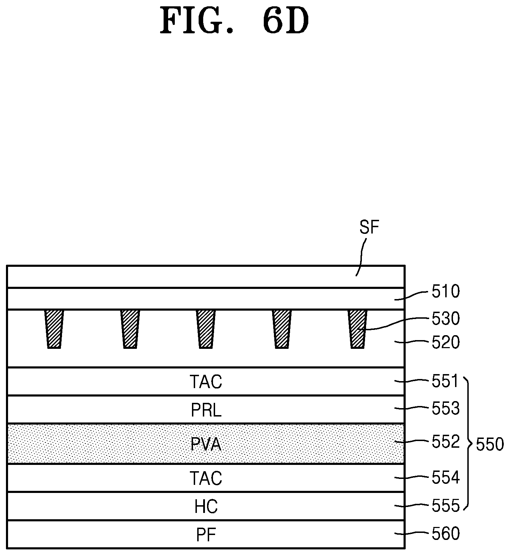

Next, referring to FIG. 6D, the adhesive layer 510 and a temporary protective film SF are formed on the transparent layer 520 and the plurality of light blocking lines 530. The adhesive layer 510 may be a PSA. The temporary protective film SF may be a non-adhesive film.

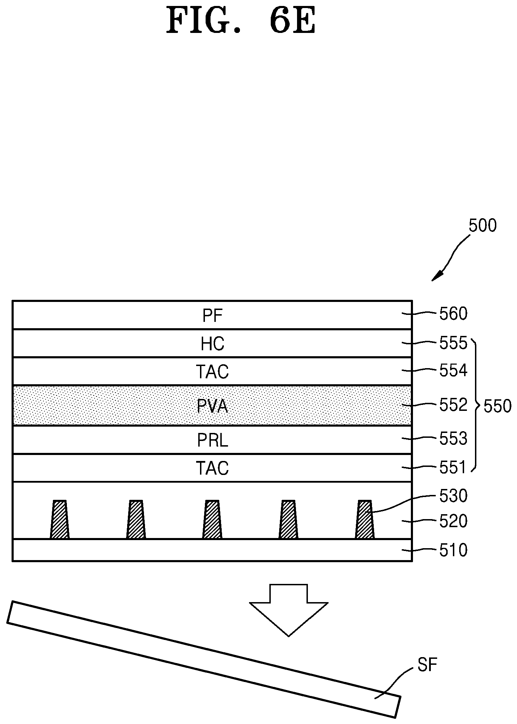

Referring to FIG. 6E, the temporary protective film SF may be removed immediately before attachment to the encapsulation structure 300 (see FIG. 4A), the adhesive layer 510 may be contact with the encapsulation structure 300, and then the optical control polarization film 500 may be attached to the encapsulation structure 300.

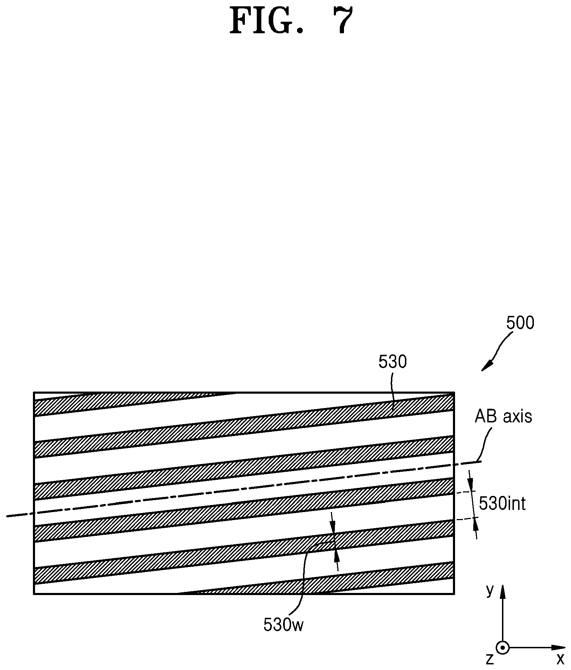

FIG. 7 is a plan view illustrating a part of an optical control polarization film.

Referring to FIG. 7, the plurality of light blocking lines 530 may extend in a certain direction in the optical control polarization film 500. The certain direction may be an absorption (AB) axis of the optical control polarization film 500. For example, the plurality of light blocking lines 530 may extend in a direction of the AB axis.

The optical control polarization film 500 may have a horizontal side in the first direction (e.g., the x direction) and a vertical side in the second direction (e.g., the y direction). The horizontal side and the vertical side of the optical control polarization film 500 may respectively correspond to a horizontal side and a vertical side of the display area DA (see FIG. 2) of the display apparatus.

The AB axis of the optical control polarization film 500 may be formed with an inclination of about 5° to about 7° with respect to the first direction (e.g., the x direction). Because the plurality of light blocking lines 530 extend in the direction of the AB axis, the plurality of light blocking lines 530 may extend while being inclined at about 5° to about 7° with respect to the first direction (e.g., the x direction).

The reason why the plurality of light blocking lines 530 extend in the direction of the AB axis and have an inclination of about 5° to about 7° with respect to the first direction may be to prevent or reduce moire. Because the plurality of light blocking lines 530 are directly formed on the polarization film layer 550 in the optical control polarization film 500 of embodiments, the plurality of light blocking lines 530 may be easily formed to extend in the direction of the AB axis.

The plurality of light blocking lines 530 may be spaced apart from each other at a first interval 150int that is a regular interval. The first interval 530int may be a shortest distance between adjacent light blocking lines. For example, the first interval 530int may be a distance from an edge of a first light blocking line to an edge of a second light blocking line adjacent to the first light blocking line. The first interval 530int may range from 30 µm to 60 µm. A width 530w of the light blocking line 530 may be about 10 µm.

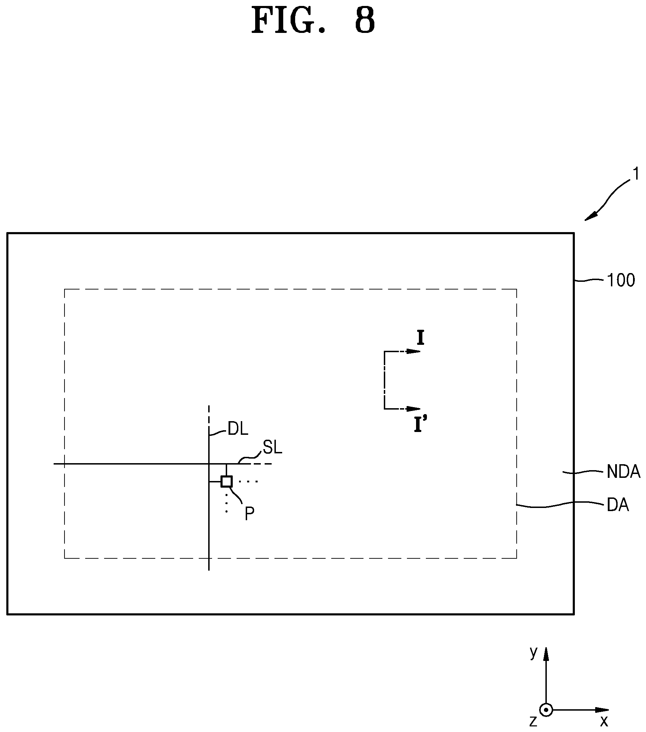

FIG. 8 is a plan view schematically illustrating the display apparatus 1, according to an embodiment.

Referring to FIG. 8, the display apparatus 1 may include the display area DA and the non-display area NDA. The display apparatus 1 may include the substrate 100 and a multi-layer film on the substrate 100. The display area DA and the non-display area NDA may be defined on the substrate 100 and/or the multi-layer film. For example, the display area DA and the non-display area NDA may be defined on the substrate 100. For example, the substrate 100 may include the display area DA and the non-display area NDA.

A plurality of sub-pixels P may be disposed in the display area DA. The plurality of sub-pixels P may display an image. The sub-pixel P may be connected to a scan line SL that extends in the first direction (e.g., the x direction) and a data line DL that extends in the second direction (e.g., the y direction).

The non-display area NDA may be disposed outside the display area DA. The non-display area NDA may at least partially surround the display area DA. In an embodiment, the non-display area NDA may entirely surround the display area DA. A scan driver for applying a scan signal to each sub-pixel P may be disposed in the non-display area NDA. A data driver for applying a data signal to the sub-pixel P may be disposed in the non-display area NDA. The non-display area NDA may include a pad area. In an embodiment, a pad may be disposed in the pad area. The pad may be exposed without being covered by an insulating layer, and may be electrically connected to a printed circuit board or a driver integrated circuit (IC). Signals and/or voltages received from the printed circuit board or the driver IC through the pad may be transmitted to the sub-pixel P disposed in the display area DA through a wiring connected to the pad.

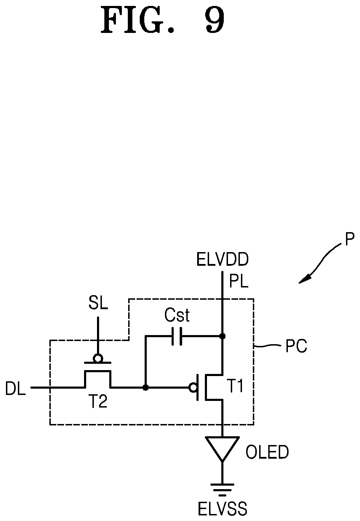

FIG. 9 is an equivalent circuit diagram schematically illustrating the sub-pixel P, according to an embodiment.

Referring to FIG. 9, the sub-pixel P may include a pixel circuit PC and an organic light-emitting diode OLED as a light-emitting device. The pixel circuit PC may include a driving transistor T1, a switching transistor T2, and a storage capacitor Cst. The sub-pixel P may emit, for example, red light, green light, or blue light, or may emit red light, green light, blue light, or white light, through the organic light-emitting diode OLED.

The switching transistor T2 may be connected to the scan line SL and the data line DL, and may transmit a data signal or a data voltage input from the data line DL to the driving transistor T1 based on a scan signal or a switching voltage input from the scan line SL. The storage capacitor Cst may be connected to the switching transistor T2 and a driving voltage line PL, and may store a voltage corresponding to a difference between a voltage received from the switching transistor T2 and a first power supply voltage ELVDD supplied to the driving voltage line PL.

The driving transistor T1 may be connected to the driving voltage line PL and the storage capacitor Cst, and may control driving current flowing through the organic light-emitting diode OLED from the driving voltage line PL in response to a value of the voltage stored in the storage capacitor Cst. The organic light-emitting diode OLED may emit light having a certain luminance due to the driving current. A common electrode (e.g., a cathode) of the organic light-emitting diode OLED may receive a second power supply voltage ELVSS. Although the pixel circuit PC includes two transistors and one storage capacitor in FIG. 9, in an embodiment, the pixel circuit PC may include three or more transistors.

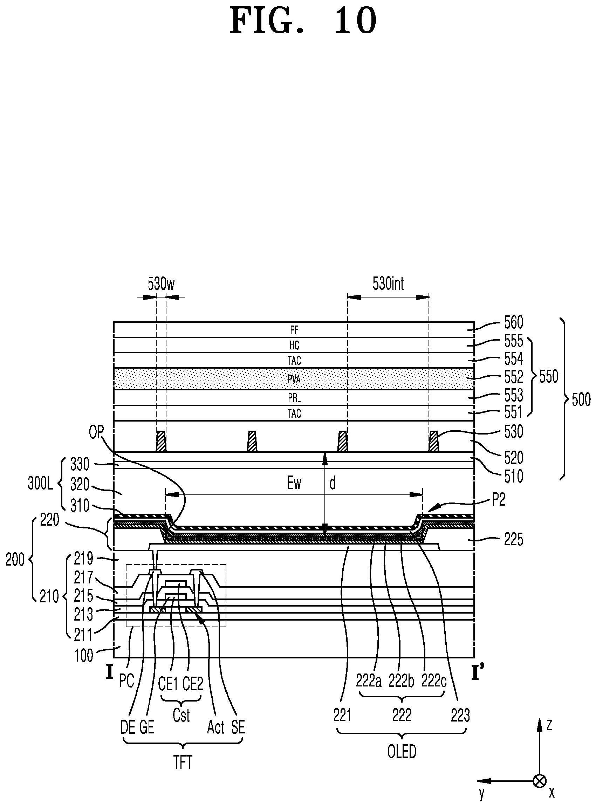

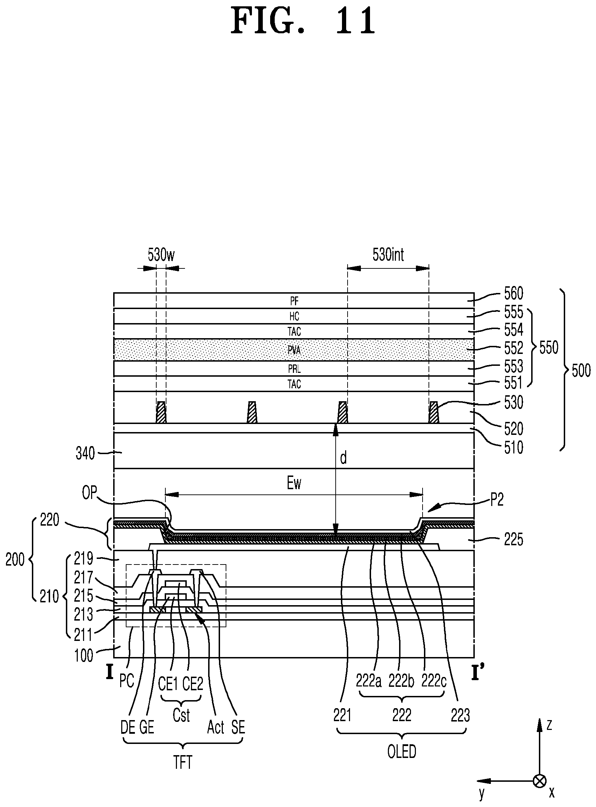

FIGS. 10 and 11 are each a cross-sectional view schematically illustrating a part of the display apparatus 1 of FIG. 9, taken along line I-I'. The same structures as those in FIGS. 4A to 5 may be denoted by the same reference numerals, and thus, elements that have not been described with respect to one drawing may be at least similar to corresponding elements that have been described with respect to other drawings.

Referring to FIGS. 10 and 11, the display apparatus 1 may include the substrate 100, the display layer 200, the encapsulation layer 300L, and the optical control polarization film 500.

The display layer 200 may be disposed on the substrate 100. The display layer 200 may include a pixel circuit layer 210 and a light-emitting device layer 220. The pixel circuit layer 210 may include a buffer layer 211, a first gate insulating layer 213, a second gate insulating layer 215, an interlayer insulating layer 217, an organic insulating layer 219, and a pixel circuit PC. The pixel circuit PC may include a thin-film transistor TFT and a storage capacitor Cst. The thin-film transistor TFT may include a semiconductor layer Act, a gate electrode GE, a source electrode SE, and a drain electrode DE.

The buffer layer 211 may be disposed on the substrate 100. The buffer layer 211 may include an inorganic insulating material such as silicon nitride (SiNₓ), silicon oxynitride (SiON), or silicon oxide (SiO₂), and may have a single or multi-layer structure including the inorganic insulating material.

The semiconductor layer Act may be disposed on the buffer layer 211. The semiconductor layer Act may include polysilicon. Alternatively, the semiconductor layer Act may include amorphous silicon, an oxide semiconductor, or an organic semiconductor. The semiconductor layer Act may include a channel region, and a drain region and a source region disposed on both sides of the channel region.

The first gate insulating layer 213 may be disposed on the semiconductor layer Act and the buffer layer 211. The first gate insulating layer 213 may include an inorganic insulating material such as silicon oxide (SiO₂), silicon nitride (SiNₓ), silicon oxynitride (SiON), aluminum oxide (Al₂O₃), titanium oxide (TiO₂), tantalum oxide (Ta₂O₅), hafnium oxide (HfO₂), or zinc oxide (ZnOₓ). Zinc oxide (ZnOₓ) may include zinc oxide (ZnO) and/or zinc peroxide (ZnO₂).

The gate electrode GE may be disposed on the first gate insulating layer 213. The gate electrode GE may overlap the channel region. The gate electrode GE may include a low-resistance metal material. The gate electrode GE may include a conductive material including molybdenum (Mo), aluminum (Al), copper (Cu), or titanium (Ti), and may have a single or multi-layer structure including one or more of the above material.

The second gate insulating layer 215 may be disposed on the gate electrode GE and the first gate insulating layer 213. The second gate insulating layer 215 may include an inorganic insulating material such as silicon oxide (SiO₂), silicon nitride (SiNₓ), silicon oxynitride (SiON), aluminum oxide (Al₂O₃), titanium oxide (TiO₂), tantalum oxide (Ta₂O₅), hafnium oxide (HfO₂), or zinc oxide (ZnOₓ), like the first gate insulating layer 213.

An upper electrode CE2 of the storage capacitor Cst may be disposed on the second gate insulating layer 215. The upper electrode CE2 may at least partially overlap the gate electrode GE that is disposed below the upper electrode CE2. In this case, the gate electrode GE and the upper electrode CE2 overlapping each other with the second gate insulating layer 215 therebetween may constitute the storage capacitor Cst. For example, the gate electrode GE may function as a lower electrode CE1 of the storage capacitor Cst. In an embodiment, the storage capacitor Cst and the thin-film transistor TFT may overlap each other. In some embodiments, the storage capacitor Cst might not overlap the thin-film transistor TFT. The upper electrode CE2 may include aluminum (Al), platinum (Pt), palladium (Pd), silver (Ag), magnesium (Mg), gold (Au), nickel (Ni), neodymium (Nd), iridium (Ir), chromium (Cr), calcium (Ca), molybdenum (Mo), titanium (Ti), tungsten (W), and/or copper (Cu), and may have a single or multi-layer structure including one or more of the above material.

The interlayer insulating layer 217 may be disposed on the upper electrode CE2 and the second gate insulating layer 215. The interlayer insulating layer 217 may include silicon oxide (SiO₂), silicon nitride (SiNₓ), silicon oxynitride (SiON), aluminum oxide (Al₂O₃), titanium oxide (TiO₂), tantalum oxide (Ta₂O₅), hafnium oxide (HfO₂), and/or zinc oxide (ZnOₓ). The interlayer insulating layer 217 may have a single or multi-layer structure including the above inorganic insulating material.

Each of the drain electrode DE and the source electrode SE may be disposed on the interlayer insulating layer 217. Each of the drain electrode DE and the source electrode SE may be electrically connected to the semiconductor layer Act. Each of the drain electrode DE and the source electrode SE may include a material having a relatively high electrical conductivity. Each of the drain electrode DE and the source electrode SE may include a conductive material including molybdenum (Mo), aluminum (Al), copper (Cu), or titanium (Ti), and may have a single or multi-layer structure including the above material. In an embodiment, each of the drain electrode DE and the source electrode SE may have a multi-layer structure including Ti/Al/Ti.

The organic insulating layer 219 may be disposed on the drain electrode DE, the source electrode SE, and the interlayer insulating layer 217. The organic insulating layer 219 may include an organic insulating material such as a general-purpose polymer such as polymethyl methacrylate (PMMA) or polystyrene (PS), a polymer derivative having a phenol-based group, an acrylic polymer, an imide-based polymer, an aryl ether-based polymer, an amide-based polymer, a fluorinated polymer, a p-xylene-based polymer, a vinyl alcohol-based polymer, or a blend thereof. In some embodiments, the organic insulating layer 219 may include a first organic insulating layer and a second organic insulating layer.

The light-emitting device layer 220 may be disposed on the pixel circuit layer 210. The light-emitting device layer 220 may be disposed on the organic insulating layer 219. The light-emitting device layer 220 may include a light-emitting device that implements a sub-pixel. The light-emitting device may be an organic light-emitting diode OLED. The light-emitting device layer 220 may include a first organic light-emitting diode, a second organic light-emitting diode, and a third organic light-emitting diode. In FIGS. 8A and 8B, the organic light-emitting diode OLED may implement a second sub-pixel P2.

The organic light-emitting diode OLED may include a pixel electrode 221, an intermediate layer 222, and a counter electrode 223. The pixel electrode 221 may be electrically connected to the thin-film transistor TFT through a contact hole of the organic insulating layer 219. The pixel electrode 221 may include a conductive oxide such as indium tin oxide (ITO), indium zinc oxide (IZO), zinc oxide (ZnO), indium oxide (In₂O₃), indium gallium oxide (IGO), or aluminum zinc oxide (AZO). In an embodiment, the pixel electrode 221 may include a reflective film including silver (Ag), magnesium (Mg), aluminum (Al), platinum (Pt), palladium (Pd), gold (Au), nickel (Ni), neodymium (Nd), iridium (Ir), chromium (Cr), or a compound thereof. In an embodiment, the pixel electrode 221 may further include a film formed of ITO, IZO, ZnO, or In₂O₃ over/under the reflective film. For example, the pixel electrode 221 may have a multi-layer structure including ITO/Ag/ITO. A pixel-defining film 225 may cover an edge of the pixel electrode 221. The pixel-defining film 225 may include an opening portion OP. The opening portion OP may expose a central portion of the pixel electrode 221. The opening portion OP may define an emission area of light emitted by the organic light-emitting diode OLED. In an embodiment, a width Ew of the emission area may be defined by a size of the opening portion OP in the second direction (e.g., the y direction). The width Ew of the emission area may be 117 µm. In an embodiment, the pixel-defining film 225 may include an organic material and/or an inorganic material. In an embodiment, the pixel-defining film 225 may be transparent. In some embodiments, the pixel-defining film 225 may include a black matrix. In this case, the pixel-defining film 225 may be opaque.

The intermediate layer 222 may include a first functional layer 222a, an emission layer 222b, and a second functional layer 222c. The emission layer 222b may include a high molecular weight organic material or a low molecular weight organic material that emits light of a certain color. In an embodiment, the first functional layer 222a and/or the second functional layer 222c may be a common layer entirely disposed over a display area. The first functional layer 222a may include, for example, a hole transport layer (HTL), or may include an HTL and a hole injection layer (HIL). The second functional layer 222c may include an electron transport layer (ETL) and/or an electron injection layer (EIL). In some embodiments, the second functional layer 222c may be omitted.

The counter electrode 223 may be disposed on the emission layer 222b. The counter electrode 223 may be formed of an electrically conductive material having a relatively low work function. For example, the counter electrode 223 may include a (semi)transparent layer including silver (Ag), magnesium (Mg), aluminum (Al), platinum (Pt), palladium (Pd), gold (Au), nickel (Ni), neodymium (Nd), iridium (Ir), chromium (Cr), lithium (Li), calcium (Ca), or an alloy thereof. Alternatively, the counter electrode 223 may further include a layer formed of ITO, IZO, ZnO, or In₂O₃ on the (semi)transparent layer including the above material.

In some embodiments, a capping layer may be further disposed on the counter electrode 223. The capping layer may include LiF, an inorganic material, and/or an organic material. An encapsulation structure may be disposed on the display layer 200. Referring to FIG. 10, the encapsulation structure may include the encapsulation layer 300L. The encapsulation layer 300L may include at least one inorganic encapsulation layer and at least one organic encapsulation layer. In FIG. 10, the encapsulation layer 300L includes a first inorganic encapsulation layer 310, an organic encapsulation layer 320, and a second inorganic encapsulation layer 330 that are sequentially stacked. In this case, a thickness of the encapsulation layer 300L may be about 10 µm.

Referring to FIG. 11, the encapsulation structure may include the encapsulation substrate 340. In an embodiment, a thickness of the encapsulation substrate 340 in a third direction (e.g., the z direction) may be about 300 µm.

The optical control polarization film 500 may be disposed on the encapsulation structure. The optical control polarization film 500 may be attached to the encapsulation substrate 340 by the adhesive layer 510 disposed in a lower portion of the optical control polarization film 500.

The optical control polarization film 500 includes the adhesive layer 510, the transparent layer 520, the plurality of light blocking lines 530, and the polarization film layer 550. The polarization film layer 550 may include the first protective layer 551, the phase retardation layer 553, the polarization layer 552, the second protective layer 554, and the hard coating layer 555.

The transparent layer 520 may include a plurality of grooves. The plurality of grooves may be arranged at a regular interval. The plurality of light blocking lines 530 may respectively fill the plurality of grooves. The plurality of light blocking lines 530 may be spaced apart from each other at a first interval 530int that is a regular interval. The first interval 530int may range from 30 µm to 60 µm. A width 530w of the light blocking line 530 in the second direction (e.g., the y direction) may be about 10 µm. The plurality of light blocking lines 530 may include a light blocking material. In a cross-sectional view, an inclination of the light blocking line 530 with respect to a top surface of the substrate 100 may be about 3.1°. A tapering angle of a side surface of the groove disposed in the transparent layer 520 may be about 3.1° with respect to the top surface of the substrate 100.

The width Ew of the emission area in the second direction may be a multiple of the first interval 530int that is an interval between the light blocking lines 530. In this case, moire may be prevented or reduced. Accordingly, the quality of the display apparatus 1 may be increased.

Also, in an embodiment, a size of a ghost image may be minimized by minimizing a vertical distance d between the emission layer 222b and the plurality of light blocking lines 530. Accordingly, the quality of the display apparatus 1 may be increased.

As the vertical distance d between the emission layer 222b and the plurality of light blocking lines 530 increases, a size of a ghost image increases. For example, a width Gw of the ghost image may satisfy the following equation.

Gw = tanθ x d (where θ is a viewing angle and d is a vertical distance between the emission layer and the light blocking lines).

In general, when a polarization film is separately provided, the polarization film is first attached to an encapsulation structure and then an optical path control film including a plurality of light blocking lines for controlling an optical path is attached to the polarization film. In this case, a distance between the emission layer 222b and the plurality of light blocking lines 530 may be about 740 µm. In this case, a width of a ghost image may be about 539 µm.

In order to reduce a size of a ghost image, the plurality of light blocking lines 530 are disposed closer to the display layer 200.

However, even when the transparent layer 520 including the plurality of light blocking lines 530 is formed on a separate base film and is provided closer to a display layer than a polarization film, it may be difficult to prevent a ghost image due to a thickness of the base film and double refraction due to the base film.

According to embodiments, because the polarization film layer 550 is disposed on the plurality of light blocking lines 530 and the plurality of light blocking lines 530 are directly formed on the polarization film layer 550, instead of a base film, the distance d between the emission layer 222b and the plurality of light blocking lines 530 may be significantly reduced, and because the base film that causes double refraction is excluded, a ghost image may be minimized from being visible.

In some embodiments, a distance between the emission layer 222b and the plurality of light blocking lines 530 may range from about 10 µm to about 300 µm. In this case, a width of a ghost image may range from about 7 µm to about 218 µm. For example, according to embodiments, because the distance d between the emission layer 222b and the plurality of light blocking lines 530 is significantly reduced to minimize a width of a ghost image, the ghost image may be prevented from being visible to a user.

It should be understood that embodiments described herein may be considered in a descriptive sense. Descriptions of features or aspects within each embodiment should typically be considered as available for other similar features or aspects in other embodiments. While one or more embodiments have been described with reference to the figures, it will be understood by one of ordinary skill in the art that various changes in form and details may be made therein without departing from the spirit and scope of the present disclosure.

## Claims

1. A display apparatus, comprising:
a substrate comprising a display area and a non-display area;
a display layer disposed in the display area and comprising a pixel circuit and a light-emitting device;
an encapsulation structure at least partially covering the display layer; and
an optical control polarization film disposed on the encapsulation structure and comprising a transparent layer and a polarization layer, wherein a plurality of light blocking lines are disposed in the transparent layer,
wherein the plurality of light blocking lines are disposed closer to the display layer than to the polarization layer.

2. The display apparatus of claim 1, wherein the plurality of light blocking lines extend in a first direction, the plurality of light blocking lines extend in a second direction, and an absorption axis of the polarization layer also extends in the second direction.

3. The display apparatus of claim 1, wherein the transparent layer comprises a plurality of grooves, and the plurality of light blocking lines respectively fill the plurality of grooves.

4. The display apparatus of claim 1, wherein the optical control polarization film further comprises a first protective layer disposed between the transparent layer and the polarization layer,
wherein the transparent layer is in direct contact with the first protective layer, and wherein the first protective layer comprises tri-acetyl cellulose (TAC), cyclo-olefin polymer, and/or polymethyl methacrylate (PMMA).

5. The display apparatus of claim 1, wherein a vertical distance from an emission layer of the light-emitting device to the plurality of light blocking lines ranges from about 10 µm to about 300 µm.

6. The display apparatus of claim 1, wherein the plurality of light blocking lines are spaced apart from each other at a first interval in one direction.

7. The display apparatus of claim 6, wherein a width of an emission area of the light-emitting device in the one direction is a multiple of the first interval.

8. The display apparatus of claim 1, wherein the encapsulation structure comprises an encapsulation layer in which at least one inorganic encapsulation layer and at least one organic encapsulation layer are alternately stacked.

9. The display apparatus of claim 1, wherein the encapsulation structure comprises an encapsulation substrate disposed on the display layer and a sealing structure configured to bond the substrate to the encapsulation substrate in the non-display area.

10. The display apparatus of claim 1, wherein an adhesive layer is disposed on a surface of the optical control polarization film facing the encapsulation structure.

11. The display apparatus of claim 1, wherein the optical control polarization film further comprises a hard coating layer disposed on the polarization layer, and the hard coating layer has a hardness of about 3 H to about 9 H.

12. A vehicle, comprising:
a pair of side window glasses spaced apart from each other in a first direction; and
a display apparatus disposed between the pair of side window glasses,
wherein the display apparatus comprises:
a substrate comprising a display area and a non-display area;
a display layer disposed in the display area and comprising a pixel circuit and a light-emitting device;
an encapsulation structure at least partially covering the display layer; and
an optical control polarization film disposed on the encapsulation structure and comprising a transparent layer and a polarization layer, wherein a plurality of light blocking lines are disposed in the transparent layer,
wherein the plurality of light blocking lines are disposed closer to the display layer than to the polarization layer.

13. The vehicle of claim 12, wherein, in the display apparatus, the plurality of light blocking lines extend in a first direction, the plurality of light blocking lines extend in a second direction, and an absorption axis of the polarization layer also extends in the second direction.

14. The vehicle of claim 12, wherein, in the display apparatus, the transparent layer comprises a plurality of grooves, and the plurality of light blocking lines respectively fill the plurality of grooves.

15. The vehicle of claim 12, wherein the optical control polarization film further comprises a first protective layer disposed between the transparent layer and the polarization layer,
wherein the transparent layer is in direct contact with the first protective layer, and
wherein the first protective layer comprises tri-acetyl cellulose (TAC), cyclo-olefin polymer, and/or polymethyl methacrylate (PMMA).

16. The vehicle of claim 12, wherein, in the display apparatus, a vertical distance from an emission layer of the light-emitting device to the plurality of light blocking lines ranges from about 10 µm to about 300 µm.

17. The vehicle of claim 12, wherein the encapsulation structure comprises an encapsulation layer in which at least one inorganic encapsulation layer and at least one organic encapsulation layer are alternately stacked.

18. The vehicle of claim 12, wherein the encapsulation structure comprises an encapsulation substrate disposed on the display layer and a sealing structure configured to bond the substrate to the encapsulation substrate in the non-display area.

19. The vehicle of claim 12, wherein an adhesive layer is disposed on a surface of the optical control polarization film facing the encapsulation structure.

20. The vehicle of claim 12, wherein the optical control polarization film further comprises a hard coating layer disposed on the polarization layer, and the hard coating layer has a hardness of about 3H to about 9H.
